(19) Europäisches Patentamt / European Patent Office / Office européen des brevets

(11) **EP 2 340 439 B1**

(12) **EUROPÄISCHE PATENTSCHRIFT**

(45) Veröffentlichungstag und Bekanntmachung des Hinweises auf die Patenterteilung:
**17.07.2013 Patentblatt 2013/29**

(21) Anmeldenummer: **08875221.7**

(22) Anmeldetag: **23.10.2008**

(51) Int Cl.:
**G01R 19/25** *(2006.01)*  **G01R 22/10** *(2006.01)*

(86) Internationale Anmeldenummer:
**PCT/EP2008/064371**

(87) Internationale Veröffentlichungsnummer:
**WO 2010/045978 (29.04.2010 Gazette 2010/17)**

(54) **VORRICHTUNG UND VERFAHREN ZUM ERFASSEN DES VERBRAUCHS ELEKTRISCHER ENERGIE**

APPARATUS AND METHOD FOR DETECTING THE CONSUMPTION OF ELECTRICAL ENERGY

DISPOSITIF ET PROCÉDÉ POUR DÉTERMINER LA CONSOMMATION D'ÉNERGIE ÉLECTRIQUE

(84) Benannte Vertragsstaaten:
**AT BE BG CH CY CZ DE DK EE ES FI FR GB GR HR HU IE IS IT LI LT LU LV MC MT NL NO PL PT RO SE SI SK TR**

(43) Veröffentlichungstag der Anmeldung:
**06.07.2011 Patentblatt 2011/27**

(73) Patentinhaber: **Siemens Aktiengesellschaft**
**80333 München (DE)**

(72) Erfinder: **SALMUTTER, Wolfgang**
**A-1020 Wien (AT)**

(56) Entgegenhaltungen:
**US-A- 4 547 726      US-A- 4 715 000**
**US-B1- 6 185 508**

- **PHADKE A G ET AL: "A New Measurement Technique for Tracking Voltage Phasors, Local System Frequency, and Rate of Change of Frequency" IEEE TRANSACTIONS ON POWER APPARATUS AND SYSTEMS, IEEE INC. NEW YORK, US, Bd. PAS-100, Nr. 5, 1. Mai 1983 (1983-05-01), Seiten 1025-1038, XP011170046 ISSN: 0018-9510**
- **I.N. BRONSTEIN, K.A. SEMENDJAEV: "Taschenbuch der Mathematik" 1999, HARRI DEUTSCH , FRANKFURT AM MAIN 381712 , XP002540970 Seite 85, Absatz 2.8.7**

**Beschreibung**

Technisches Gebiet

Die Erfindung betrifft ein Verfahren zum Erfassen des Verbrauchs von elektrischer Energie, die in einem Energieverteilungsnetz an einen Verbraucher geliefert wird, wobei ein Messsignal, das der Wechselspannung am Verbraucher entspricht, mit einer Abtastfrequenz abgetastet und einer komplexen Fourieranalyse unterworfen wird, und wobei die Abtastfrequenz einer schwankenden Netzfrequenz des Energieverteilungsnetzes nachgeführt wird.

Stand der Technik

Zur Messung der elektrischen Energie, die in einem Energieverteilungsnetz an einen Verbraucher geliefert wird, werden heutzutage neben mechanischen Energiezähler zunehmend auch elektronische eingesetzt.

Ein elektronischer Energiezähler ermittelt durch Abtastung eines Messsignals, das der dem Verbraucher zugeführten Wechselspannung beziehungsweise dem Wechselstrom entspricht, zeitdiskrete Abtastwerte, unterwirft diese beispielsweise einer komplexen Fourieranalyse und ermittelt daraus, durch Multiplikation der komplexen Strom- und Spannungszeiger, die gelieferte elektrische Leistung beziehungsweise elektrische Energie, wobei auch Oberschwingungen im Strombeziehungsweise Spannungssignal berücksichtigt werden.

In einem Energieverteilungsnetz hat die Grundfrequenz oder Nennfrequenz der Netzspannung einen vorgegebenen Wert (Europa 50 Hz, USA 60 Hz). Diese Nennfrequenz schwankt aber, je nach der erzeugerseitig angebotenen und von den Verbrauchern augenblicklich aufgenommenen elektrischen Momentanleistung. Unter normalen Betriebsbedingungen ist die zulässige Schwankungsbreite der Netzfrequenz durch eine Norm vorgegeben. Die Norm EN 50160 schreibt beispielsweise vor, dass der 10-Sekunden-Mittelwert der Grundfrequenz während der gesamten Zeit bezüglich 50 Hz nur um 15% nach oben beziehungsweise um 15% nach unten abweichen darf.

Für einen elektronischen Energiezähler bedeutet dies, dass zumindest innerhalb dieser vorgegebenen Schwankungsbreite die Abtastfrequenz an die schwankende Netzfrequenz adaptiert, das heißt nachgeführt werden können muss. Nur wenn die Anzahl der Abtastpunkte bezogen auf die Grundschwingung der schwankenden Netzfrequenz konstant gehalten werden kann, werden sogenannte "Leakage-Effekte" vermieden und die geforderte Messgenauigkeit erreicht. Bei fehlender Synchronisation zwischen der Abtastfrequenz und der augenblicklichen Netzfrequenz kann es zu einem unzulässig großen Fehler bei der Verbrauchsermittlung der elektrischen Energie kommen.

Neben stetigen Frequenzänderungen muss ein elektronischer Energiezähler auch sprungförmige Frequenzänderungen, wie sie beispielsweise beim Einschalten des Energiezählers auftreten, beherrschen.

Obere und untere Grenzen der stetigen beziehungsweise sprungförmigen Frequenzänderung werden von behördlicher Seite beziehungsweise durch Norm vorgegeben.

Eine Nachführung der Abtastfrequenz kann beispielsweise so realisiert sein, dass die Abtastfrequenz von einem Frequenzteiler abgeleitet wird und dieser in Abhängigkeit der Frequenzabweichung fortlaufend entsprechend justiert wird. Voraussetzung ist, dass die Frequenzabweichung bekannt ist. Um die Frequenzabweichung zu ermitteln, ist bekannt, die Nulldurchgänge der Netzfrequenz entweder durch Hardware oder durch Software zu erfassen.

In einem Energieverteilungsnetz sind Spannung und Strom aber nicht rein sinusförmig, sondern es können Oberschwingungen und/oder einen Gleichanteil enthalten sein.

Hinsichtlich der Nachführung der Abtastfrequenz sind sowohl Oberschwingungen als auch ein Gleichanteil störend, denn sie bewirken ein Verschleifen der Nulldurchgänge. Aus verschliffenen Nulldurchgängen lässt sich nur mit einem hohen technischen Aufwand das richtige Taktmaß für die Abtastung hinreichend genau ableiten.

Um bei einem elektronischen Energiezähler den störenden Einfluss von Oberschwingungen oder eines Gleichanteils zu mindern, ist bekannt, diese Störgrößen mittels (relativ steiler) Tiefpass- oder Bandpassfilter zu beseitigen.

Solche Filter, die in Hardware oder Software realisiert sein können, vergrößern aber den technischen Aufwand und damit auch die Herstellungskosten eines elektronischen Energiezählers.

Die Patentschrift US 6 185 508 B1 offenbart eine elektronische Energieverbauchsmeßeinrichtung, welche für schwankende Frequenzen geeignet sein soll, welche jedoch das bekannte und mit einer Vielzahl an Nachteilen versehene Nulldurchgangsbestimmungsverfahren einsetzt.

In US 4 715 000 ist eine sogenannte PLL offenbart mittels welcher ein Abtastsignal einer variablen Eingangsfrequenz nachgeführt werden soll. Dabei wird ein Phasendifferenzwinkel zwischen 2 Perioden einer Eingangsgröße ermittelt und daraus auf die Schwankung der Frequenz der Eingangsgröße geschlossen.

Eine Frequenzbestimmungsmethode, welche insbesondere für energietechnische Anwendungen vorteilhaft sein soll ist in US 4 547 726 offenbart. Diese verzichtet auf die Methode der Nullpunktsbestimmung und ermittelt stattdessen einen Frequenzabweichungsvektor.

Ein Verfahren zur Bestimmung der Frequenz, Frequenzabweichung und Frequenzabweichungsgeschwindigkeit in einem elektrischen Netz ist in "A New Measurement Technique for Tracking Voltage Phasors, Local System Frequency, and Rate of Change of Frequency", IEEE TRANSACTION ON POWER APPARATUS AND SYSTEMS, IEEE INC. NEW YORK, US4, Phadke A G et al, Bd. PAS-100, Nr.5, 1.Mai 1983, Seiten 1025-1038, XP011170046, ISSN: 0018-9510 offenbart. Gemäß dieses Verfahrens wird auch die Phasendifferenz der Vektoren nacheinanderfolgender Perioden eines Eingangssignals herangezogen, die Nullpunktsbestimmung solcherart umgangen. Allerdings setzt das genannte Verfahren die Amplitudengleichheit der beiden Vektoren voraus.

Darstellungen der Erfindung

Es ist eine Aufgabe der vorliegenden Erfindung, ein Verfahren zum Erfassen des Verbrauchs von elektrischer Energie anzugeben, bei dem auf möglichst einfache Weise die Abtastfrequenz an eine schwankende Netzfrequenz nachgeführt wird und so eine hohe Messgenauigkeit erreicht werden kann.

Diese Aufgabe wird durch ein Verfahren mit den Merkmalen des Anspruchs 1 und durch einen elektronischen Energiezähler mit den Merkmalen des Anspruchs 7 gelöst.

Vorteilhafte Ausgestaltungen der Erfindung sind in den abhängigen Ansprüchen definiert.

Gemäß einem Grundgedanken der Erfindung wird bei einem elektronischen Energiezähler fortlaufend aus zwei aufeinander folgenden Perioden eines von der Spannung abgeleiteten Messsignals die Phasendifferenz der Grundschwingung mittels komplexer Fourieranalyse ermittelt und als Taktmaß bei der Nachführung der Abtastfrequenz verwendet. Die ermittelte Phasendifferenz, d.h. der zwischen den Zeigern eingeschlossene Phasenwinkel, bildet die Frequenzabweichung direkt ab. Das heißt, wenn in zwei aufeinander folgenden Perioden des abgetasteten Messsignals die Netzfrequenz konstant ist, ist die Phasendifferenz null. Schwankt hingegen die Netzfrequenz, so bildet sich das Ausmaß dieser Schwankung direkt in der Größe des Differenzwinkels zwischen den beiden Zeigern der Grundschwingung der Messgröße ab. Steht die Größe der Frequenzabweichung einmal fest, kann der Phasenwinkel in einen entsprechenden digitalen Wert umgerechnet werden und in an sich bekannter Weise einem Frequenzteiler zugeführt werden, der die Abtastfrequenz entsprechend nachzieht.

Ein wesentlicher Vorteil des erfindungsgemäßen Verfahrens ist darin zu sehen, dass der Algorithmus für die Ermittlung der Phasendifferenz vergleichsweise einfach realisiert werden kann. Eine Hardware oder eine Software zum Erfassen der Nulldurchgänge ist nicht erforderlich. Dies vereinfacht den technischen Aufbau eines elektronischen Energiezählers.

Bevorzugte Ausgestaltungen des erfindungsgemäßen Verfahrens verwenden zur Nachführung der Abtastfrequenz einen Phasenwinkel, der gemäß der weiter unten näher erläuterten Gleichungen (9), (11), (12a) und (12b) berechnet wird.

Hinsichtlich des rechentechnischen Aufwandes kann es günstig sein, wenn bei der Ermittlung der Phasendifferenz ein Quotient aus Vektorprodukt und Skalarprodukt gemäß Gleichung (9) ermittelt wird. Dadurch kann der Fehler bei der Ermittlung der elektrischen Energie auch dann sehr gering gehalten werden, wenn bei der Berechnung des Arcustangens bekannte Näherungsalgorithmen (Reihenentwicklungen) verwendet werden. Sobald die Regelung nämlich "eingerastet" ist, ergeben sich immer sehr kleine Phasendifferenzwinkel, die auch bei einer näherungsweisen Berechnung durch die Arcustangensfunktion hinreichend genau ermittelt werden können ($\arctan(x) - x$ für $x << 1$ und damit fast keine Rechenungenauigkeit)

Wenn eine größere Schwankungsbreite der Netzfrequenz zugelassen werden soll kann es günstig sein, wenn bei der rechentechnischen Umsetzung gemäß der Gleichung (9) im Nenner eine Betragsbildung durchgeführt wird und die Phasendifferenz gemäß der Gleichung (11) berechnet wird. Dadurch vergrößert sich der "Fangbereich" des Nachführ-Algorithmus.

Um auch in Fällen, in denen sich die Netzfrequenz um mehr als 25% gegenüber der Momentanfrequenz ändert, möglichst rasch eine Adaption zu erzielen, ist in einer besonderen Ausgestaltung der Erfindung eine Fallunterscheidung vorgesehen:

Ist das Skalarprodukt negativ und der ermittelte Phasenwinkel größer als Null, wird das Taktmaß für die Abtastfrequenz gemäß der Gleichung (12a) ermittelt.

Ist das Skalarprodukt negativ und der ermittelte Phasenwinkel kleiner als Null, wird das Taktmaß für die Abtastfrequenz gemäß der Gleichung (12b) ermittelt. Dies verkürzt die Laufzeit des Nachführ-Algorithmus und damit die Zeit für die Korrektur der Abtastfrequenz.

Eine besonders günstige Ausgestaltung des erfindungsgemäßen Verfahrens kann dadurch gekennzeichnet sein, dass die Abtastfrequenz von einem Frequenzteiler abgeleitet wird, und diesem Frequenzteiler ein Vorteiler vorgeschaltet ist, wobei dem Vorteiler fortlaufend eine digitale Größe, die der Phasendifferenz entspricht, zugeführt wird, und wobei diese Größe auf eine Schwankungsbreite von +/-19% der Nennfrequenz angepasst ist.

Ein besonders günstiges Verhältnis zwischen dem rechentechnischen Aufwand, der Rechengeschwindigkeit und der Messgenauigkeit lässt sich dadurch erreichen, indem eine Periode des Messsignals mit 256 Abtastwerten abgetastet wird.

Besonders günstig ist es, wenn bei der Nachführung der Abtastfrequenz eine größere Schwankungsbreite der Netzfrequenzänderung abgedeckt wird, als die Norm vorgibt. Daher ist ein besondere Ausgestaltung der Erfindung dadurch gekennzeichnet, dass der erfindungsgemäß ermittelte Phasenwinkel auf eine Schwankungsbreite von +/- 19% der Netzfrequenz bezüglich einer dem Energieverteilungsnetz zugeordneten Nennfrequenz beschränkt wird. Dies kommt einer Reserve bei der Nachregelung der Abtastfrequenz gleich.

Ein elektronischer Energiezähler, der mit einer Recheneinrichtung ausgestattet ist, auf welcher ein Programmcode nach dem erfindungsgemäßen Verfahren implementiert ist, kann vergleichsweise einfach hergestellt werden. Damit lässt sich mit guter Genauigkeit und über eine lange Betriebsdauer zuverlässig die an einen Verbraucher gelieferte elektrische Energie messen.

Kurzbeschreibung der Zeichnungen

Zur weiteren Erläuterung der Erfindung wird im nachfolgenden Teil der Beschreibung auf die Zeichnungen Bezug genommen, in denen weitere vorteilhafte Ausgestaltungen, Einzelheiten und Weiterbildungen der Erfindung zu entnehmen sind.
Es zeigt:

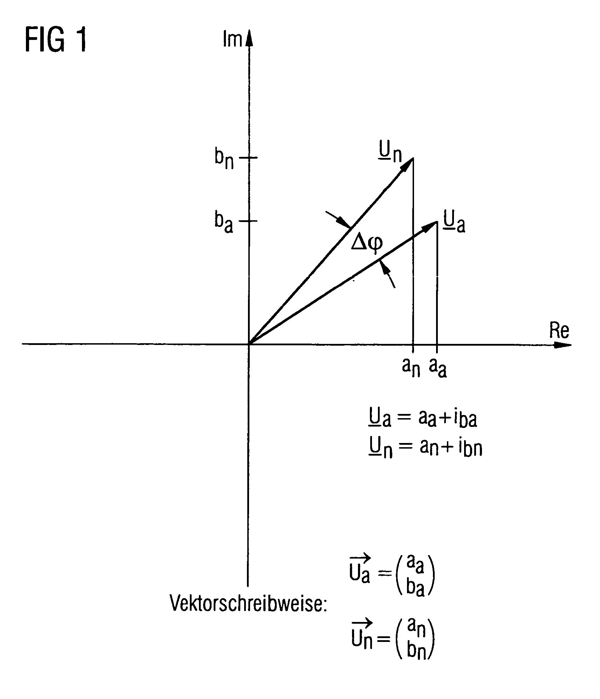

Figur 1    eine Zeigerdarstellung der Grundschwingung eines Messsignals in zwei aufeinander folgenden Perioden, wobei das Messsignal der Spannung eines Verbrauchers in einem Energieverteilungsnetz entspricht, und wobei gemäß der Erfindung der zwischen den Zeigern eingeschlossene Phasenwinkel (Phasendifferenz) zur Nachführung der Abtastfrequenz an eine schwankende Netzfrequenz herangezogen wird;

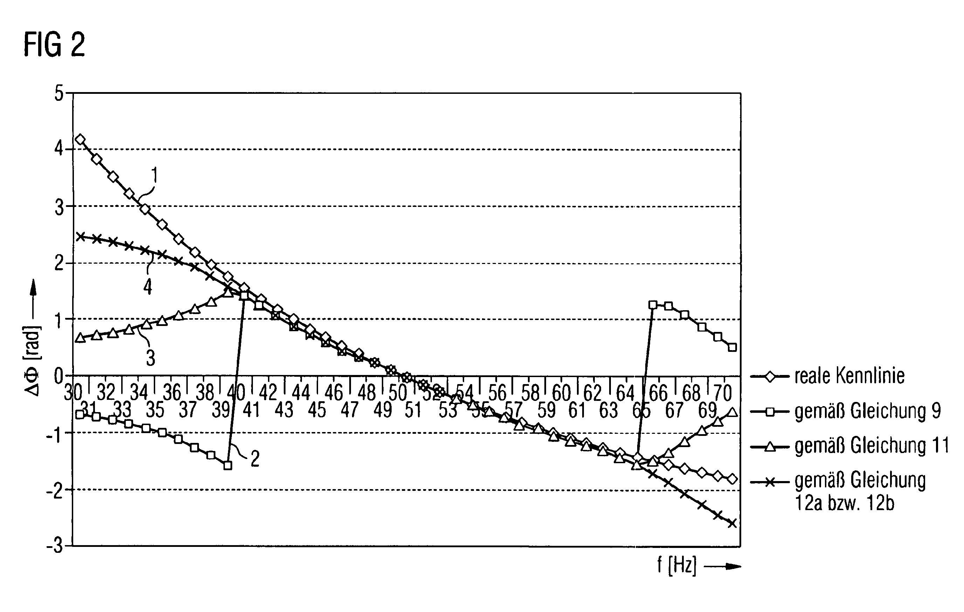

Figur 2    ein Diagramm in welchem die Phasendifferenz über der Netzfrequenz aufgetragen ist, wobei verschiedene Varianten der erfindungsgemäßen Ermittlung des Phasenwinkels durch ein Kennlinienfeld veranschaulicht sind, und wobei der Fall der nominellen Netzfrequenz von 50 Hz gewählt ist.

Ausführung der Erfindung

Wie bereits einleitend gesagt, kann die geforderte Genauigkeit eines elektronischen Energiezählers nur dadurch erreicht werden, indem die Anzahl der Abtastpunkte bezogen auf die Grundschwingung konstant gehalten wird, da es sonst durch so genannte "Leakage-Effekte" zu Messungenauigkeiten kommen würde. Mit anderen Worten, die Abtastfrequenz muss mit der tatsächlichen Netzfrequenz synchronisiert, das heißt regelungstechnisch nachgeführt werden (Frequenznachregelung). Üblicherweise wird für diese Frequenznachregelung ein durch Software einstellbarer Frequenzteiler verwendet, dessen Ausgangsfrequenz als Abtastfrequenz dient und das Teilerverhältnis eine entsprechende Feinjustierung der Abtastfrequenz ermöglicht. Ein elektronischer Energiezähler ermittelt den Energieverbrauch durch Abtastung und Fourieranalyse. Stimmen die momentane Netzfrequenz und die Abtastfrequenz geringfügig nicht überein, so wirkt sich dies in der Fourieranalyse so aus, dass die Grundschwingungs-Zeiger zweier aufeinander folgender Perioden gegeneinander gedreht erscheinen (siehe Figur 1). Der Phasenwinkel $\Delta\varphi$ zwischen den beiden Zeigern liefert dabei ein direktes Kriterium für die Periodendauer und somit für die aktuelle Netzfrequenz. Diesen Effekt nutzt die vorliegende Erfindung und verwendet den Phasenwinkel zur Nachführung der Abtastfrequenz. Da der Phasenwinkel aus der diskreten komplexen Fouriertransformation gewonnen wird, wird er im Folgenden auch als DFT-Phasenwinkel bezeichnet.

Regelungstechnisch gesehen stellt der DFT-Phasenwinkel eine Regelabweichung dar. Die aktuelle Netzfrequenz kann als Führungsgröße angesehen werden, der die Abtastfrequenz als Regelgröße folgen soll. Als Stellgröße fungiert der dem Frequenzteiler zugeführte digitale (Vorteiler-) Wert.

Bevor verschiedene Ausführungen des erfindungsgemäßen Verfahrens anhand einer Simulation näher erläutert werden, seien mathematische Grundlagen vorangestellt:

Die Figur 1 zeigt eine Darstellung der komplexen Ebene mit zwei Zeigern $\vec{Ua}$, $\vec{Un}$. Die beiden Zeiger $\vec{Ua}$ und $\vec{Un}$ sind das Ergebnis einer komplexen Fourieranalyse von zwei aufeinander folgenden Perioden eines von der Netzspannung abgeleiteten Messsignals. Der Zeiger mit dem Index a kennzeichnet dabei die zeitfern abgetastete Periode des Messsignals, der Zeiger mit dem Index n die zeitnah abgetastete Periode. Die beiden Zeiger werden fortlaufend aus den Abtastwerten mittels Fourieranalyse ermittelt.

Die Gleichungen (1) und (2) zeigen den mathematischen Zusammenhang zur Ermittlung des Realteils $a_{a,n}$ und des Imaginärteils $b_{a,n}$ der komplexen Grundschwingungs- und Oberschwingungs-Zeiger.

$$a_{a,n} = \operatorname{Re} X(k) = \frac{2}{N} \sum_{n=0}^{N-1} x(n) * \cos(2\pi nk / N) \qquad (1)$$

$$b_{a,n} = \operatorname{Im} X(k) = \frac{-2}{N} \sum_{n=0}^{N-1} x(n) * \sin(2\pi nk / N) \qquad (2)$$

Für die Grundschwingung gilt k=1.

Aus Real- und Imaginärteil dieser Zeiger kann bekanntlich entsprechend Gleichung (3) und (4) die Amplitudeninformation und die Phaseninformation des zu messenden Signals (Strom oder Spannung) gewonnen werden:

$$|X(k)| = \sqrt{\operatorname{Re} X(k)^2 + \operatorname{Im} X(k)^2} \qquad (3)$$

$$\varphi[X(k)] = \arctan\left(\frac{\operatorname{Im} X(k)}{\operatorname{Re} X(k)}\right) \qquad (4)$$

Aus der Gleichung (4) könnte man den Phasenwinkel aus den einzelnen Winkeln der Zeiger berechnen. Da dies aber rechentechnisch aufwändig ist, nicht zuletzt aufgrund der Reihenentwicklung der Arcustangens-Funktion, wählt die Erfindung einen anderen Weg:

In der Gleichung (5) ist der Sinus des Phasenwinkels Δφ als Vektorprodukt (x) dargestellt:

$$\sin(\Delta\varphi) = \frac{\vec{U}_n \times \vec{U}_a}{\left|\vec{U}_n\right| * \left|\vec{U}_a\right|} \qquad (5)$$

In der Gleichung (6) ist der Cosinus des Phasenwinkels Δφ als Skalarprodukt (°) dargestellt:

$$\cos(\Delta\varphi) = \frac{\vec{U}_n \circ \vec{U}_a}{\left|\vec{U}_n\right| * \left|\vec{U}_a\right|} \qquad (6)$$

Aus (5) und (6) folgt der Tangens des Phasenwinkels Δφ als Quotient von Vektorprodukt und Skalarprodukt:

$$\tan(\Delta\varphi) = \frac{\vec{U}_n \times \vec{U}_a}{\vec{U}_n \circ \vec{U}_a} \qquad (7)$$

Ausgehend von diesen mathematischen Grundlagen wird das erfindungsgemäße Verfahren im Folgenden anhand einer Simulation näher erläutert.

In der Figur 2 ist die Phasendifferenz (in Radiant) über der Netzfrequenz (in Hz) aufgetragen. Auf der Abszisse ist eine Schwankungsbreite der Netzfrequenz von 30 Hz bis 70 Hz dargestellt; die Kennlinien 2, 3 und 4 veranschaulichen in diesem Bereich unterschiedliche Ausprägungen der Erfindung.

Weicht die Netzfrequenz von der nominellen Netzfrequenz innerhalb der in Figur 2 dargestellten Schwankungsbreite (30 Hz bis 70 Hz) ab, so drückt sich diese Abweichung als Phasendifferenz zwischen den Zeigern aus, was in einer "idealisierten" Darstellung die Kennlinie 1 zeigt. "Idealisiert" deswegen, da Kennlinie 1 die reale Phasenabweichung zeigt; man kann sie mittels einer Rechnung oder durch eine exakte Messung der Nulldurchgänge gewinnen. Die Kennlinie 1 kann als Sollwertvorgabe für den Algorithmus der Nachführung der Abtastfrequenz an eine schwankende Netzfrequenz angesehen werden.

Im Vergleich zu Kennlinie 1 zeigen die Kennlinien 2, 3, und 4 verschiedene Verläufe des Phasenwinkels, die durch Simulation der Algorithmen (Gleichung 9, 11, 12a und 12b) zur Ermittlung des Phasenwinkels gewonnen wurden.

Bei der Simulation wird beispielhaft eine Abtastfrequenz von 12,8 kHz verwendet; dies bedeutet 256 Abtastwerten pro Periode. Die Abtastfrequenz wird von einem Frequenzteiler abgeleitet. Die Eingangfrequenz des Frequenzteilers beträgt 133,3248 MHz (nominales Teilerverhältnis 10.416), so dass bei Änderung des Teilerverhältnisses eine sehr feine Abstufung der Abtastfrequenz (im Bereich von 0,01%) möglich ist. Es hat sich in der Praxis gezeigt, dass die oben angegebenen Werte des Ausführungsbeispiels einen guten Kompromiss zwischen der Genauigkeit bei der Energiemessung und der Effizienz der rechentechnisch eingesetzten Ressourcen darstellen.

Wie aus der Figur 2 zu entnehmen ist, liefert im Bereich von kleinen Frequenzabweichungen (d.h. im Bereich der Nominalfrequenz von 50 Hz) jeder der ermittelte DFT-Phasenwinkel-Kennlinien (Kennlinien 2, 3 und 4) ein mit der Kennlinie 1 übereinstimmendes Ergebnis. Ein wesentlicher Vorteil der Erfindung ist aber darin zu sehen, dass die Ergebnisse 3, und 4 mit einem vergleichsweise sehr geringeren softwaretechnischen Aufwand erreicht werden können.

Aus der Gleichung (7) erhält man den Phasenwinkel $\Delta\varphi$ zu

$$\Delta\varphi = \arctan\left(\frac{\vec{U}_n \times \vec{U}_a}{\vec{U}_n \circ \vec{U}_a}\right) \qquad (8)$$

Beispielsweise wird der Phasenwinkel $\Delta\varphi$ gemäß der folgenden Gleichung (9) berechnet.

$$\Delta\varphi = \arctan\left(\frac{a_n * b_a - b_n * a_a}{a_n * a_a + b_n * b_a}\right) \qquad (9)$$

Die Simulation dieser Berechnung ist in Figur 2 durch die Kennlinie 2 dargestellt.

Hierbei wird bei der Berechnung der Intervalllänge INT im Bogenmaß folgende Gleichung (10) verwendet:

$$INT = 2\pi + \Delta\varphi \qquad (10)$$

Wenn zwischen den beiden betrachteten Perioden des Messsignals die Netzfrequenz nicht schwankt, ist die Intervalllänge gleich 2n, da der Phasenwinkel $\Delta\varphi$ gleich null ist. Schwankt hingegen die Netzfrequenz, so ist der Phasenwinkel $\Delta\varphi$ ungleich null und es wird ein der Intervalllänge entsprechender digitaler Wert dem Vorteiler zum Erzeugen der neuen (nachgeführt) Abtastfrequenz zugeführt.

Innerhalb der Schwankungsbreite von 40 Hz bis 65 Hz entspricht der simulierte Verlauf weitgehend dem der realen Kennlinie 1. Außerhalb dieses Bereichs 40 Hz bis 65 Hz versagt allerdings diese Ausführung des erfindungsgemäßen Algorithmus gemäß Gleichung (9). Der Grund liegt darin, dass bei der Berechnung des Phasenwinkels $\Delta\varphi$, bei einem Frequenzsprung der Netzfrequenz, der einem Phasensprung betragsmäßig größer $\pi/2$ entspricht, eine Vorzeichenumkehr des DFT-Phasenwinkels auftritt (wie aus der Figur 2, Kennlinie 2 ersichtlich ist, würde für den Fall, dass die Netzfrequenz kleiner circa 40 Hz ist, fälschlicherweise in Richtung höhere Frequenzen geregelt werden; entsprechendes gilt für eine nach zu regelnde Netzfrequenz größer als 65 Hz). Die Erfindung löst dieses Problem dadurch, indem Gleichung (9) dahingehend modifiziert wird, dass anstelle des Skalarproduktes der beiden Vektoren der Absolutbetrag des Skalarproduktes verwendet wird (Gleichung 11):

$$\Delta\varphi_{mod1} = \arctan\left(\frac{a_n * b_a - b_n * a_a}{|a_n * a_a + b_n * b_a|}\right) \qquad (11)$$

Durch diese Maßnahme kann ein erweiterter Fangbereich der Nachführung der Abtastfrequenz (Frequenznachregelung), die ja einer PLL Schaltung entspricht, erzielt werden. In Figur 2 ist dieses Simulationsergebnis durch die Kennlinie 3 dargestellt.

Wie man aus dieser Kennlinie 3 der Figur 2 unschwer ablesen kann, liegt außerhalb des Bereichs, der einem Phasensprung betragsmäßig größer $\pi/2$ entspricht, der DFT Phasenwinkel $\Delta\varphi_{mod1}$ zwar nun vorzeichenrichtig vor, hat aber einen gegenläufigen Verlauf (die Kennlinie 3 fällt mit Frequenzen unter 40 Hz und steigt mit Frequenzen über 65 Hz, diese Bereiche sind am negativen Vorzeichen des Skalarproduktes erkennbar).

Eine Verbesserung der Adaptionsgeschwindigkeit des erfindungsgemäßen Verfahrens lässt sich dadurch erreichen, indem Fallunterscheidungen getroffen werden und der errechnete DFT-Phasenwinkel $\Delta\varphi_{mod1}$ entsprechend seinem Vorzeichen von $+\pi$ oder $-\pi$ subtrahiert wird.

Diese Fallunterscheidung ist in den Gleichungen (12a) und (12b) ausgedrückt:

$$\vec{U}_n \circ \vec{U}_a < 0 \; \text{und} \; \Delta\varphi_{mod1} > 0 \Rightarrow \Delta\varphi_{mod2} = \pi - \Delta\varphi_{mod1} \qquad (12a)$$

$$\vec{U}_n \circ \vec{U}_a < 0 \; \text{und} \; \Delta\varphi_{mod1} < 0 \Rightarrow \Delta\varphi_{mod2} = -\pi - \Delta\varphi_{mod1} \qquad (12b)$$

Mit dieser besonders bevorzugten Variante der Erfindung ($\Delta\varphi_{mod2}$) lässt sich das beste Ergebnis erzielen. Wie aus der Figur 2 unschwer zu entnehmen ist, kommt Kennlinie 4, die mit Gleichung (12a) bzw. (12b) berechnet wurde, dem idealen Verlauf (Nachführkennlinie 1) am nächsten.

Wie eingangs erwähnt, wird seitens der Norm EN 50160 die Beherrschung einer Frequenzabweichung von +/- 15% vom Nominalwert 50 Hz, das heißt 42,5 Hz bis 57,5 Hz, gefordert.

Es ist aber von Vorteil, wenn in der Frequenznachregelung noch eine Reserve implementiert ist, und ein Arbeitsbereich von +/- 19% (das heißt von 40,5 Hz bis 59,5 Hz) abgedeckt wird.

Der technische Hintergrund für die Festlegung dieser Untergrenzen und Obergrenze ist folgender: Die theoretische Grenze dieses Regelalgorithmus bei Frequenzsprüngen liegt bei +/- 50% bezogen auf die momentane Frequenz. Dies ist dadurch bedingt, dass es ab dieser Grenze auch bei Berechnung des DFT Phasendiffernzwinkels gemäss Gleichung 11 oder Gleichungen 12a und 12b zu einer Vorzeichenumkehr käme. Würde beispielsweise beim Einschalten des elektronischen Energiezählers die aktuelle Frequenz 30 Hz betragen, so müsste ein Frequenzsprung von 50 Hz (Anfangsfrequenz des Regelalgorithmus nach einen Hochlauf) auf 30 Hz beherrscht werden. Die Ausregelung dieses Sprungs ist möglich (-40% bezogen auf 50 Hz). Käme es anschließend wieder zu einem Rücksprung von 30 Hz auf 50 Hz, so würde der Algorithmus allerdings versagen, denn diese Abweichung beträgt mehr als 50% bezogen auf 30 Hz. Die oben genannten Grenzen stellen aber sicher, dass bei Rückkehr in den "Arbeitsbereich" eine problemlose Nachregelung erfolgt, und zwar egal welchen Wert die Frequenz vorher hatte und auch unabhängig davon, wohin gesprungen wird. Im vorliegenden Beispiel würde bei einem Sprung auf 30 Hz die Regelung an der Untergrenze 40,5 Hz "hängen bleiben", der Rücksprung auf 50 Hz ist aber problemlos (es wäre sogar ein Sprung an die Obergrenze möglich). Die Grenzen wurden so gewählt, dass bei einem Sprung von unten nach oben, (das ist der kritische Sprung mit einer größeren prozentualen Abweichung als von oben nach unten) die Abweichung bezogen auf die untere Frequenz kleiner 50% beträgt.

Wie bereits oben erwähnt, zeigt die Figur 2 den Fall der nominellen Netzfrequenz 50 Hz. Im Falle dass die Netzfrequenz von dieser nominellen Netzfrequenz abdriftet, beispielsweise auf 45 Hz, wird die Taktfrequenz an diese neue "Zielfrequenz " 45 Hz herangeführt. Sobald dieser Vorgang der Nachführung (Nachregelung) abgeschlossen ist, ist die Figur 2 so zu lesen, dass auf der Abszisse der Schnittpunkt mit den Kennlinien 1 bis 4 nicht mehr 50 Hz heißt, sondern 45 Hz Entsprechendes gilt natürlich, wenn im weiteren Verlauf die Netzfrequenz auch vom diesem neuen Wert 45 Hz abweicht. Mit anderen Worten, wenn die Netzfrequenz fortlaufend schwankt, ist in Figur 2 die Abszisse fortlaufend neu zu skalieren.

Zusammenstellung der verwendeten Bezugszeichen

| 1 | reale ("idealisierte") (Nachführ)Kennlinie, Sollfrequenz |
|---|---|
| 2 | Kennlinie gemäß Gleichung (9) |
| 3 | Kennlinie gemäß Gleichung (11) |
| 4 | Kennlinie gemäß Gleichung (12a) und (12b) |

**Patentansprüche**

1. Verfahren zum Erfassen des Verbrauchs von elektrischer Energie, die in einem Energieverteilungsnetz an einen Verbraucher geliefert wird, wobei ein Messsignal, das der Wechselspannung am Verbraucher entspricht, mit einer Abtastfrequenz abgetastet und einer komplexen Fourieranalyse unterworfen wird, und wobei die Abtastfrequenz einer schwankenden Netzfrequenz des Energieverteilungsnetzes nachgeführt wird, **dadurch gekennzeichnet, dass** fortlaufend aus zwei aufeinander folgenden Perioden des Messsignals jeweils ein Zeiger ($\vec{U}_a, \vec{U}_n$) der Grundschwingung ermittelt wird, dass der zwischen den beiden Zeigern eingeschlossene Phasenwinkel ($\Delta\varphi$) ermittelt wird und bei der Nachführung der Abtastfrequenz verwendet wird, und **dass** bei der Nachführung ein Phasenwinkel $\Delta\varphi$ mod1 verwendet wird, der gemäß der Beziehung

$$\Delta\varphi_{\mathrm{mod1}} = \arctan\left(\frac{a_n * b_a - b_n * a_a}{|a_n * a_a + b_n * b_a|}\right)$$

ermittelt wird wobei

$a_a$ der Realteil des Zeigers $\vec{U}a$,
$b_a$ der Imaginärteil des Zeigers $\vec{U}_a$
$a_n$ der Realteil des Zeigers $\vec{U}_n$,
$b_n$ der Imaginärteil des Zeigers $\vec{U}_n$ ist.

2. Verfahren nach Anspruch 1, **dadurch gekennzeichnet, dass** für den Fall eines Frequenzsprungs, der einem Phasensprung größer + $\pi$/2 entspricht, bei der Nachführung ein Phasenwinkel $\Delta\varphi_{\mathrm{mod2}}$ verwendet wird, der gemäß der Beziehung

$$\vec{U}_n \circ \vec{U}_a < 0 \, \mathrm{und} \, \Delta\varphi_{\mathrm{mod1}} > 0 \Rightarrow \Delta\varphi_{\mathrm{mod2}} = \pi - \Delta\varphi_{\mathrm{mod1}}$$

ermittelt wird.

3. Verfahren nach Anspruch 2, **dadurch gekennzeichnet, dass** für den Fall eines Frequenzsprungs, der einem Phasensprung kleiner - $\pi$/2 entspricht, bei der Nachführung ein Phasenwinkel $\Delta\varphi_{\mathrm{mod2}}$ verwendet wird, der gemäß der Beziehung

$$\vec{U}_n \circ \vec{U}_a < 0 \, \mathrm{und} \, \Delta\varphi_{\mathrm{mod1}} < 0 \Rightarrow \Delta\varphi_{\mathrm{mod2}} = -\pi - \Delta\varphi_{\mathrm{mod1}}$$

ermittelt wird.

4. Verfahren nach einem der Ansprüche 1 bis 3, **dadurch gekennzeichnet, dass** die Abtastfrequenz von einem Frequenzteiler erzeugt wird, wobei dem Frequenzteiler ein Vorteiler vorgeschaltet ist welchem ein digitaler Wert, der dem ermittelten Phasenwinkel entspricht, zugeführt wird.

5. Verfahren nach einem der Ansprüche 1 bis 4, **dadurch gekennzeichnet, dass** eine Periode des Messsignals mit 256 Abtastwerten abgetastet wird.

**6.** Verfahren nach einem der Ansprüche 1 bis 5, **dadurch gekennzeichnet, dass** der Phasenwinkel auf eine Schwankungsbreite, welcher einer Abweichung von +/-19% einer der dem Energieverteilungsnetz zugeordneten Netzfrequenz entspricht, beschränkt wird.

**7.** Elektronischer Energiezähler, der eine Recheneinrichtung aufweist, die zur Ausführung eines Verfahrens nach einem der Ansprüche 1 bis 6 eingerichtet ist.


**Claims**

**1.** Method for measuring the consumption of electrical energy supplied to an electricity-consuming load in an energy distribution network, wherein a measurement signal corresponding to the alternating-current voltage at the load is sampled at a sampling frequency and subjected to a complex Fourier analysis, and wherein the sampling frequency is correctively adjusted to a fluctuating supply frequency of the energy distribution network, **characterised in that** a fundamental component phasor $(\vec{U_a}, \vec{U_n})$ is continuously calculated from each of two succeeding periods of the measurement signal, **in that** the phase angle ($\Delta\varphi$) enclosed between the two phasors is determined and used in the corrective adjustment of the sampling frequency, and **in that** during the corrective adjustment a phase angle ($\Delta\varphi_{\text{mod1}}$) is used which is determined in accordance with the relation

$$\Delta\varphi_{\text{mod1}} = \arctan\left(\frac{a_n * b_a - b_n * a_a}{|a_n * a_a + b_n * b_a|}\right)$$

where

   $a_a$ is the real part of the phasor $\vec{U_a}$,
   $b_a$ is the imaginary part of the phasor $\vec{U_a}$,
   $a_n$ is the real part of the phasor $\vec{U_n}$,
   $b_n$ is the imaginary part of the phasor $\vec{U_n}$.

**2.** Method according to claim 1, **characterised in that** in the event of a frequency shift corresponding to a phase shift greater than $+ \pi/2$ a phase angle $\Delta\varphi_{\text{mod2}}$ is used for the corrective adjustment which is determined in accordance with the relation

$$\vec{U_n} \circ \vec{U_a} < 0 \quad \text{and} \quad \Delta\varphi_{\text{mod1}} > 0 \quad \Rightarrow \quad \Delta\varphi_{\text{mod2}} = \pi - \Delta\varphi_{\text{mod1}}.$$

**3.** Method according to claim 2, **characterised in that** in the event of a frequency shift corresponding to a phase shift less than $- \pi/2$ a phase angle $\Delta\varphi_{\text{mod2}}$ is used for the corrective adjustment which is determined in accordance with the relation

$$\vec{U_n} \circ \vec{U_a} < 0 \quad \text{and} \quad \Delta\varphi_{\text{mod1}} < 0 \quad \Rightarrow \quad \Delta\varphi_{\text{mod2}} = -\pi - \Delta\varphi_{\text{mod1}}.$$

**4.** Method according to one of claims 1 to 3, **characterised in that** the sampling frequency is generated by a frequency scaler, wherein connected upstream of the frequency scaler is a prescaler to which a digital value corresponding to the determined phase angle is supplied.

**5.** Method according to one of claims 1 to 4, **characterised in that** a period of the measurement signal is sampled using 256 sampling values.

**6.** Method according to one of claims 1 to 5, **characterised in that** the phase angle is restricted to a fluctuation range corresponding to a deviation of +/-19% of a supply frequency assigned to the energy distribution network.

**7.** Electronic energy meter having a computing device that is configured for performing a method according to one of claims 1 to 6.

**Revendications**

1. Procédé pour enregistrer la consommation d'énergie électrique qui est fournie à un consommateur dans un réseau de distribution d'énergie, un signal de mesure qui correspond à la tension alternative au niveau du consommateur étant balayé avec une fréquence de balayage et soumis à une analyse de Fourier complexe et la fréquence de balayage étant adaptée à une fréquence variable du réseau de distribution d'énergie, **caractérisé en ce que** respectivement un phaseur ($\vec{U_a}, \vec{U_n}$) de l'oscillation fondamentale est déterminé en continu à partir de deux périodes successives du signal de mesure, **en ce que** l'angle de phase ($\Delta\varphi$) compris entre les deux phaseurs est déterminé et utilisé lors de l'adaptation de la fréquence de balayage et **en ce qu'**est utilisé, pour l'adaptation, un angle de phase $\Delta\varphi_{mod1}$ qui est déterminé selon la relation

$$\Delta\varphi_{mod1} = \arctan\left(\frac{a_n * b_a - b_n * a_a}{|a_n * a_a + b_n * b_a|}\right)$$

où

$a_a$ est la partie réelle du phaseur $\vec{U_a}$,
$b_a$ est la partie imaginaire du phaseur $\vec{U_a}$,
$a_n$ est la partie réelle du phaseur $\vec{U_n}$ et
$b_n$ est la partie imaginaire du phaseur $\vec{U_n}$.

2. Procédé selon la revendication 1, **caractérisé en ce qu'**est utilisé pour l'adaptation, dans le cas d'un saut de fréquence correspondant à un saut de phase supérieur à + $\pi/2$, un angle de phase $\Delta\varphi_{mod2}$ qui est déterminé selon la relation

$$\vec{U_n} \circ \vec{U_a} < 0 \quad \text{et} \quad \Delta\varphi_{mod1} > 0 \Rightarrow \Delta\varphi_{mod2} = \pi - \Delta\varphi_{mod1}$$

3. Procédé selon la revendication 2, **caractérisé en ce qu'**est utilisé pour l'adaptation, dans le cas d'un saut de fréquence correspondant à un saut de phase inférieur à - $\pi/2$, un angle de phase $\Delta\varphi_{mod2}$ qui est déterminé selon la relation

$$\vec{U_n} \circ \vec{U_a} < 0 \quad \text{et} \quad \Delta\varphi_{mod1} < 0 \Rightarrow \Delta\varphi_{mod2} = -\pi - \Delta\varphi_{mod1}$$

4. Procédé selon l'une des revendications 1 à 3, **caractérisé en ce que** la fréquence de balayage est générée par un diviseur de fréquence, en amont du diviseur de fréquence étant monté un prédiviseur sur lequel est envoyée une valeur numérique qui correspond à l'angle de phase déterminé.

5. Procédé selon l'une des revendications 1 à 4, **caractérisé en ce qu'**une période du signal de mesure est balayée avec 256 valeurs de balayage.

6. Procédé selon l'une des revendications 1 à 5, **caractérisé en ce que** l'angle de phase est limité à une amplitude de variation qui correspond à un écart de +/-19 % d'une fréquence de réseau associée au réseau de distribution d'énergie.

7. Compteur d'énergie électronique comportant un dispositif de calcul qui est configuré pour exécuter un procédé selon l'une des revendications 1 à 6.

## FIG 2

EP 2 340 439 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 6185508 B1
- US 4715000 A
- US 4547726 A

**In der Beschreibung aufgeführte Nicht-Patentliteratur**

- A New Measurement Technique for Tracking Voltage Phasors, Local System Frequency, and Rate of Change of Frequency. **PHADKE A G et al.** IEEE TRANSACTION ON POWER APPARATUS AND SYSTEMS. IEEE INC, 01. Mai 1983, vol. PAS-100, 1025-1038